# EUROPEAN PATENT SPECIFICATION

(11) **EP 0 456 319 B1**
(45) Date of publication and mention of the grant of the patent: **13.03.1996**
(21) Application number: 91201067.5
(22) Date of filing: 06.05.1991
(51) Int. Cl.: H01L 29/51, H01L 29/788, H01L 21/28

(54) **Floating gate field effect transistor structure and method for manufacturing the same**
Feldeffekttransistorstruktur mit einem schwebenden Gate und Verfahren zu ihrer Herstellung
Structure de transistor à effet de champ à grille flottante et sa méthode de fabrication

(30) Priority: 11.05.1990 US 522432
(43) Date of publication of application: 13.11.1991
(73) Proprietor: Philips Electronics N.V., NL-5621 BA Eindhoven (NL)
(72) Inventor: Chen, Teh Yi James, NL-5656 AA Eindhoven (NL)
(74) Representative: Houbiers, Ernest Emile Marie Gerlach

(56) References cited:
- EP-A- 0 187 278
- EP-A- 0 301 460
- US-A- 4 426 764
- US-A- 4 881 108

## Description

The present invention relates in general to a floating gate field effect transistor structure for use in nonvolatile memories or similar structures, and a method for manufacturing the same.

Nonvolatile memories are those that can retain stored data even when power is removed from a memory chip. UV-EPROMs and EEPROMs are typically configured in this manner and employ structures which store charge in each of the memory cells. An example of this type of structure is a floating gate MOSFET which employs a composite stack gate electrode having a regular control gate disposed over an insulator surrounded floating gate. When a voltage is applied to the control gate, charge is injected from the channel region of the MOSFET into the floating gate where it can be stored for a long time after the applied voltage is removed.

The floating gate must be surrounded by a dielectric film with good isolation properties to insure that the charge is retained. One type of dielectric film consists of a thin oxide-nitride-oxide (ONO) composite layer disposed between the floating gate and the control gate and a thermally grown oxide on the sidewalls of the floating gate. The thin ONO layer is used not only to isolate the floating gate, but also to couple high voltage from the control gate to the floating gate, while the thermal oxide on the sidewalls is mainly used as the isolation dielectric between the control gate and the floating gate.

To provide good electric isolation, the sidewall oxide generally has to be grown at a fairly high temperature, usually in excess of 1050°C. Also, the corners formed between the ONO and the sidewall oxide are likely to be potential weak points for charge leakage in the standard stack gate cell design. These concerns impose severe restrictions when attempts are made at further down scaling of the memory device size. As the devices are scaled down, the temperature to which the devices are exposed during formation must be minimized in order to insure the integrity of the thin gate oxide used in the memory cells. The high oxidation temperature required to form the sidewall oxides becomes a major concern. Further, the ONO layer has to be thinned down to maintain the coupling efficiency between the control gate and the floating gate as the gate oxide thickness is reduced, and this increases the likelihood of corner leakage between the ONO layer and the sidewall oxide.

Prior techniques for insulating a floating gate from a control gate in a semiconductor memory device are illustrated in U.S. Patent No. 4,720,323 to Sato. In this patent, a first technique is disclosed in which an ONO composite layer is deposited on both the top and the sidewalls of the floating gate, while in a second technique, an ONO layer is first deposited on the top of the floating gate and then an oxide layer is deposited on the sidewalls of the gate. Both of these techniques suffer from the previously discussed drawbacks. In particular, only a small thickness of oxide is formed on the sides of the floating gate in the first technique. This increases the likelihood of corner leakage between the floating gate and the control gate. In the second technique, a fairly thick layer of oxide must be formed on the exposed gate sidewalls which requires that the gate oxide be exposed to high temperatures for an extended period of time that, in the case of scaled down devices, could damage the integrity of the thin gate oxide.

What is needed in view of these drawbacks is a process by which scaled down nonvolatile semiconductor memory devices can be formed without directly exposing the gates of the memory cells to excessive temperatures for extended periods of time while still providing a structure by which the floating gates of the cells will be properly isolated from the control gates.

It is therefore the object of the present invention to provide a method for manufacturing semiconductor structures, such as nonvolatile semiconductor memories, which does not expose the elements of the structures to excessive temperatures for extended periods of time.

It is another object of the present invention to provide a method for manufacturing semiconductor structures, such as nonvolatile semiconductor memories, which provides superior electrical isolation of the structure elements from one another.

It is yet another object of the present invention to provide a nonvolatile floating gate field effect transistor (FET) structure construction which provides superior electrical isolation of the structure's floating gate and control gate.

These and other objects of the invention are achieved with a stacked floating gate FET structure construction and a method for manufacturing the same as defined in the appended claims wherein a floating gate is isolated from a control gate of the structure by first forming a thin layer of oxide along the sidewalls of the floating gate, and then covering the oxide layer and the top of the floating gate with an ONO composite layer. The sidewall oxide layer is preferably formed by a thermal oxidation step and is relatively thin so that the floating gate does not have to be exposed to a high oxidation temperature for an extended period of time. After creating the sidewall oxide, the first layer of oxide for the ONO composite layer is grown overtop of the floating gate and the sidewall oxide in a second thermal oxidation step which again does not expose the floating gate to excessive temperatures for an extended period of time. Now that the floating gate is completely covered with oxide, the remaining nitride and oxide layers of the ONO composite layer can be formed. Finally, a control gate is formed on top of the ONO composite layer. The top corners of the floating gate are now surrounded both by the ONO composite layer and the underlying oxide layer which provide improved dielectric isolation between the floating gate and the control gate. This process also helps prevent formation of a silicon trench in the diffusion area of the structure during gate etching steps.

The foregoing and additional objects, features and advantages of the present invention will become apparent from the following detailed description thereof taken in conjunction with the accompanying drawings in which:
Fig. 1 is a schematic plan view of a floating gate field effect transistor array;
Figures 2-7 are cross sectional views taken along stepped line 1-1 of Fig. 1 illustrating the manufacturing steps for forming a floating gate field effect transistor structure in accordance with the present invention; and
Fig. 8 is a cross sectional view taken along line 2-2 of Fig. 1 showing a completed field effect transistor structure constructed in accordance with the present invention.

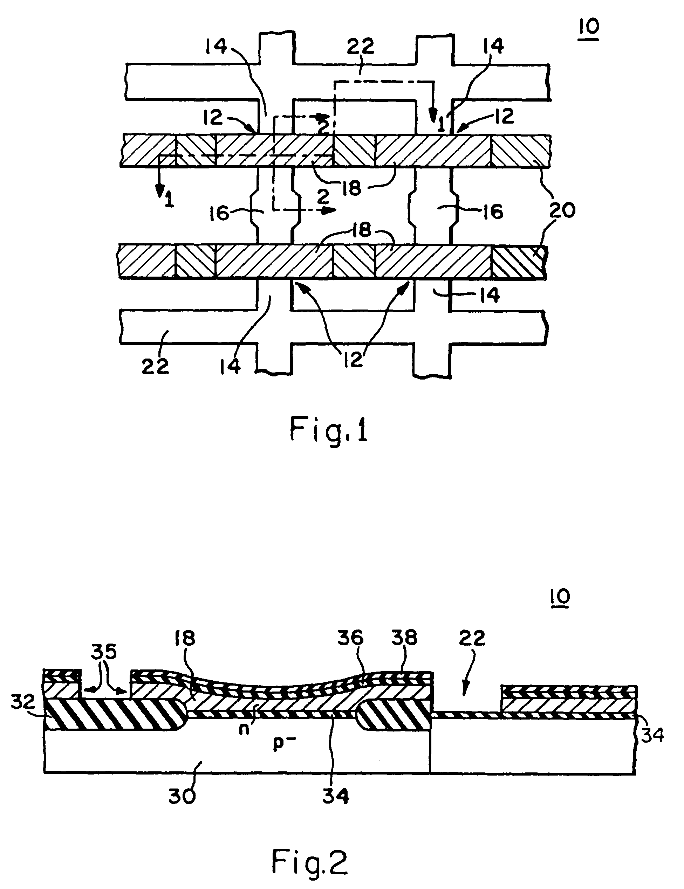

Turning now to a more detailed consideration of the present invention, a stacked floating gate FET memory array 10 is illustrated in Fig. 1 which includes a plurality of FET memory cells 12, a plurality of n-type source diffusion regions 14 and a plurality of n-type drain diffusion regions 16. First layers of n-type polysilicon 18 for the floating gates of each of the memory cells 12 overlie the source and drain diffusion regions 14 and 16, while second n-type polysilicon layers 20 for the control gates of each of the memory cells 12 overlie the floating gate polysilicon layers 18. If desired, the polysilicon layer 20 for the control gates can be replaced with a polycide structure to enhance the circuit speed. Part of each of the source diffusion regions 14 remains uncovered by the floating gate polysilicon layers 18 as indicated at 22 in Fig. 1.

Turning now to Figures 2-7, the manufacturing steps for forming one of the floating gate FET memory cells in accordance with the present invention are illustrated. In particular, the floating gate FET memory cell 12 is illustrated in a partially manufactured form including the uncovered source diffusion area 22. The FET memory array 10 includes a p-type (100) monocrystalline silicon substrate 30 on which are formed by conventional semiconductor fabrication techniques a field oxide region 32 and a silicon dioxide gate dielectric layer 34. The polysilicon floating gate layer 18 is formed over the gate oxide region 34 and adjoining field oxide region 32 and includes a pair of sidewalls 35. A thin pad layer of thermally grown silicon dioxide 36 and a thin layer of LPCVD silicon nitride 38 are formed on top of the floating gate layer 18. The preferred thicknesses of the gate oxide layer 34, floating gate layer 18, pad oxide layer 36 and nitride layer 38 are 10-20 nm, 200-250 nm, 10 nm and 15-30 nm, respectively. The formation of the layers 18, 36 and 38 is achieved by conventional deposition, photolithographic masking, and plasma etch methods.

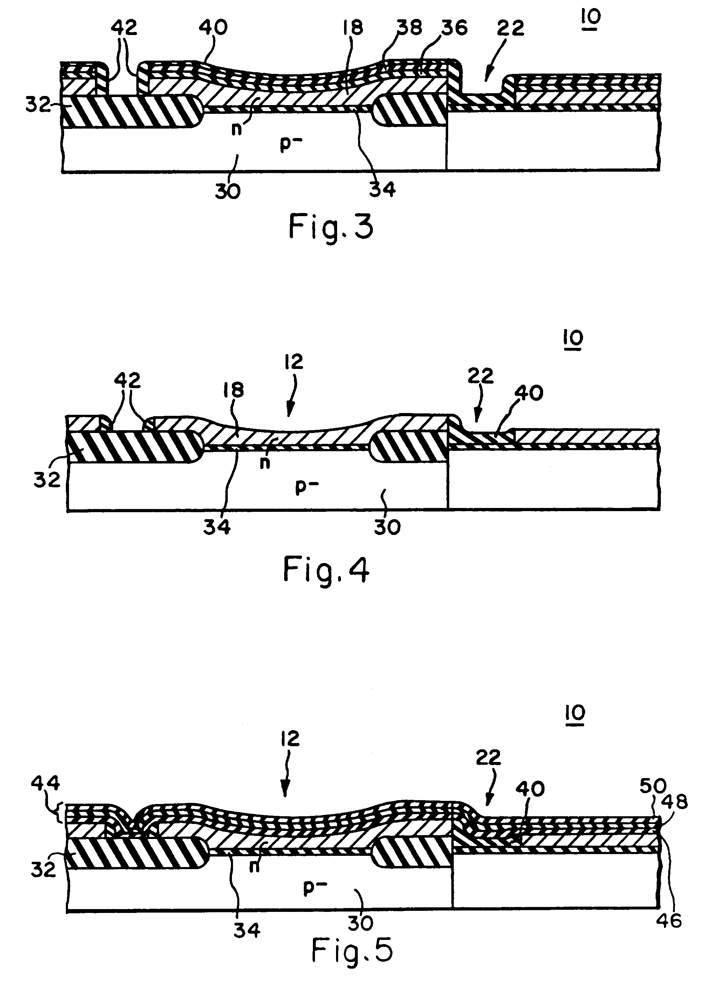

Turning now to Fig. 3, a key step of the present invention is illustrated in which a thermal oxidation at a temperature between 850°C and 950°C for approximately 5 to 30 minutes is performed to grow a thin silicon dioxide isolation layer 40 on top of the nitride layer 38, on the sidewalls 35 of the floating gate layer 18 as illustrated at 42 and on top of the silicon substrate 30 in the source diffusion area 22. The thickness of the silicon dioxide layer 40 is around 1 nm on the top silicon surfaces of the memory array 10 and, depending on the oxidation temperature and type (i.e., wet or dry oxidation), the thickness of the sidewall region oxide 42 is between 40 nm and 80 nm. The thickness of the silicon dioxide layer 40 is approximately 40 nm on top of the silicon substrate 30 in the source diffusion area 22.

Next, as illustrated in Fig. 4, the oxide, nitride and silicon dioxide layers 36, 38 and 40, respectively, in the FET memory cell 12 are removed so that only the sidewall oxide regions 42 and the portion of the silicon dioxide layer 40 in the source diffusion area 22 remain. In particular, the silicon dioxide layer 40 is removed using any suitable etchant solution, such as hydrofluoric acid (HF), after which the nitride layer 38 is removed by exposing it to hot (e.g. 150°C) phosphoric acid for approximately 20 minutes. Finally, another HF etchant solution is employed to remove the silicon dioxide layer 36 and approximately 200-250 angstroms of the sidewall region oxide 42. This leaves the thickness of the sidewall regions 42 at approximately 350-400 angstroms.

As illustrated in Fig. 5, an oxide-nitride-oxide (ONO) composite layer 44 is next formed over the entire top surface of the FET memory array 10. The ONO composite layer 44 is actually comprised of three layers 46, 48 and 50 which are formed in three corresponding steps. The first silicon dioxide layer 46 is thermally grown at a temperature between 950°C and 1100°C approximately 10-15 nm thick. This step takes approximately 10 minutes, depending on the temperature, and is preferably performed in an environment of dry oxygen with 3% chlorine. The 950°C-1100°C range is chosen because it provides the best compromise and balances the desire to achieve the highest quality silicon dioxide, which occurs at the higher temperature, with the desire to reduce the temperature exposure of the floating gate polysilicon 18. If the latter desire is of primary concern, 950°C is the most preferred temperature.

The nitride layer 48 is then deposited at 800°C for 10 minutes to a thickness of approximately 15 nm and, finally, another thermal oxidation cycle in wet oxygen is performed at 900-1000°C for 2 hours to form the silicon dioxide layer 50 to a thickness of 2-3 nm to further improve the dielectric quality of the ONO composite layer 44.

The steps illustrated in Figures 4 and 5 provide a number of advantages over prior fabrication techniques. First, the combination of the sidewall oxide regions 42 and the overlying ONO composite layer 44 provide superior electrical isolation and help insure that, as the thicknesses of the various layers are reduced to accommodate high density scaled-down technology, leakage currents will not pass from the floating gate 18 through the oxide and ONO layers 42 and 44. Secondly, the sidewall oxide regions 42 do not have to provide as much electrical isolation as in prior devices since the ONO composite layer 44 also provides electrical isolation in these areas. As a result, the sidewall oxide regions 42 can be grown at a lower temperature which further facilitates scaling down of the FET memory array 10. Thirdly, the source diffusion area 22 not covered by the floating gate layer 18 is now covered by the ONO layer 44 as well as by the oxide layer 40 grown during the sidewall oxidation step. The silicon trench that often forms in the source diffusion area during later etching steps can be prevented in this manner. To further insure that a trench will not form, an n⁺ implantation of As⁺ can be made into the source diffusion area 22 before the sidewall oxidation step. This will cause the oxide layer 40 to grow thicker over the implanted area and further prevent silicon trench formation during later gate etching steps.

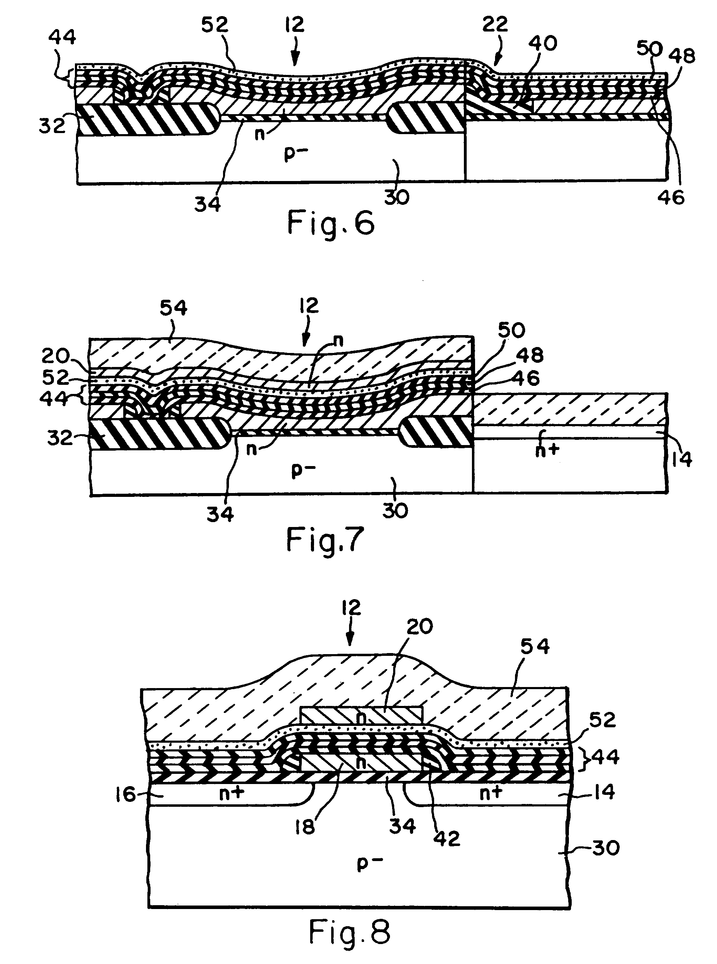

The remaining steps to manufacture the FET memory array 10 are conventional and are illustrated in Figures 6-8. In particular, a thin amorphous silicon layer 52 approximately 30 nm thick is deposited over the entire ONO layer 44 to protect it from photoresist used in later steps. The control gate polysilicon layer 20 is then deposited at a thickness of about 400-450 nm on the amorphous silicon layer 52 and delineated by conventional photoresist and etching techniques, while the n⁺ source diffusion region 14 and drain diffusion region 16 are formed, also by conventional techniques. Finally, as illustrated in Figures 7 and 8, the entire FET memory array 10 is covered with a layer of BPSG glass 54.

Although the invention has been disclosed in terms of a preferred embodiment, it will be understood that numerous variations and modifications could be made thereto without departing from the scope of the invention as set forth in the following claims. For example, although the manufacturing method has been disclosed for use in a polycide gate process, the method is also compatible with salicide process technology. Further, the conductivities of the various elements could be reversed to form p-channel FETs instead of n-channel, and the silicon dioxide gate electric layer 34 could be replaced by a silicon nitride layer.

## Claims

1. A method for manufacturing a floating gate field effect transistor in which a channel separates a source (14) and a drain (16) in a semiconductor substrate (30) so as to establish a channellength direction and a channel-width direction, the method comprising the steps of:
forming a floating gate (18) layer over a gate dielectric layer (34) situated along the substrate, the floating gate having a top surface, a pair of opposing first sidewalls (35) extending in the channel-length direction and a pair of opposing second sidewalls (35) extending in the channel-width direction;
forming sidewall oxide layers (42) on the first and second sidewalls of the floating gate;
subsequently forming a composite oxide-nitride-oxide (ONO) layer (44) on the top surface of the floating gate layer and on said sidewall oxide layers;
forming a control gate (20) over the ONO layer;
forming the source (14) and drain (16) in the semiconductor substrate.

2. A method as in Claim 1, wherein the step of forming the sidewall oxide layers (42) comprises thermally growing oxide on the first and second sidewalls of the floating gate layer.

3. A method as in Claim 2 wherein the step of thermally growing oxide is performed at a temperature between 850 °C and 950 °C.

4. A method as in Claim 3 wherein the sidewall oxide layers (42) are grown approximately 40 nm to 80 nm thick on the first and second sidewalls of the floating gate layer.

5. A method as in Claim 2, further including the steps of:
providing a nitride layer (38) on the top surface of the floating gate layer, prior to thermally growing the sidewall oxide layers (42) on the sidewalls, said nitride layer leaving free the first and second sidewalls (35) of the floating gate layer;
removing the nitride layer (38) after the step of thermally growing the sidewall oxide layers (42) on the sidewalls and prior to the step of forming the ONO layer (44).

6. A method as in any of the preceding Claims , wherein the step of forming the ONO layer comprises the steps of:
thermally growing a lower oxide layer (46) on the top surface of the floating gate layer;
depositing the nitride layer (48) on the lower oxide layer and on the sidewall oxide layers;
thermally growing an upper oxide layer (50) on the nitride layer (48).

7. A method as in Claim 6, wherein said lower oxide layer (46) is grown at a temperature between 950 °C and 1100 °C.

8. A floating gate field effect transistor structure comprising:
a semiconductor substrate (30) that includes a source (14) and a drain (16) separated by a channel so as to define a channel length direction and a channel width direction;
a gate dielectric layer (34) situated on the substrate over the channel;
a floating gate (18) situated over the gate dielectric layer, the floating gate having a top surface and a pair of first sidewalls (35) that extend in the channel-length direction and a pair of second sidewalls (35) that extend in the channel-width direction;
sidewall oxide layers (42) situated on the first and second sidewalls of the floating gate;
a composite oxde-nitride-oxide (ONO) layer (44) provided on the top surface of the floating gate, the sidewall oxide layers (42) on the first and second sidewalls of the floating gate being covered with a composite nitride-oxide layer (48,50);
a control gate (20) situated over the ONO layer.

## Patentansprüche

1. Verfahren zur Herstellung einer Feldeffekttransistorstruktur mit einem schwebenden Gate, bei welchem ein Kanal eine Source (14) und einen Drain (16) in einem Halbleitersubstrat (30) zur Ausbildung einer Richtung in Kanallänge und einer Richtung in Kanalbreite trennt, wobei das Verfahren folgende Schritte vorsieht:
Herstellung einer Schicht (18) für das schwebende Gate über einer dielektrischen Gateschicht (34) entlang dem Substrat, wobei das schwebende Gate eine Oberseite, ein Paar sich gegenüberliegende, erste Seitenwände (35), welche sich in Richtung der Kanallänge erstrecken, sowie ein Paar sich gegenüberliegende, zweite Seitenwände (35), welche sich in Richtung der Kanalbreite erstrecken, aufweist;
Herstellung von Seitenwandoxidschichten (42) auf den ersten und zweiten Seitenwänden des schwebenden Gates;
anschließende Ausbildung einer kombinierten Oxid-Nitrid-Oxid-(ONO) Schicht (44) auf der Oberseite der Schicht des schwebenden Gates sowie auf den Seitenwandoxidschichten;
Herstellung eines Steuergates (20) über der ONO-Schicht;
Herstellung der Source (14) und des Drains (16) in dem Halbleitersubstrat.

2. Verfahren nach Anspruch 1, bei welchem das Verfahren zur Ausbildung der Seitenwandoxidschichten (42) ein thermisches Aufbringen des Oxids auf den ersten und zweiten Seitenwänden der Schicht des schwebenen Gates vorsieht.

3. Verfahren nach Anspruch 2, bei welchem das thermische Aufbringen des Oxids bei einer Temperatur von 850°C bis 950°C erfolgt.

4. Verfahren nach Anspruch 3, bei welchem die Seitenwandoxidschichten (42) in einer Stärke von etwa 40 nm bis 80 nm auf den ersten und zweiten Seitenwänden der Schicht des schwebenden Gates aufgebracht werden.

5. Verfahren nach Anspruch 2, welches außerdem die folgenden Schritte vorsieht:
Aufbringen einer Nitridschicht (38) auf der Oberseite der Schicht des schwebenden Gates vor dem thermischen Aufbringen der Seitenwandoxidschichten (42) auf den Seitenwänden, wobei die ersten und zweiten Seitenwände (35) der Schicht des schwebenden Gates nicht mit der Nitridschicht versehen werden;
Entfernen der Nitridschicht (38) nach erfolgtem thermischem Aufbringen der Seitenwandoxidschichten (42) auf den Seitenwänden und vor Ausbildung der ONO-Schicht (44).

6. Verfahren nach einem der vorangegangenen Ansprüche, bei welchem die Herstellung der ONO-Schicht folgende Schritte vorsieht:
thermisches Aufbringen einer unteren Oxidschicht (46) auf der Oberseite der Schicht des schwebenden Gates;
Abscheidung der Nitridschicht (48) auf der unteren Oxidschicht sowie auf den Seitenwandoxidschichten;
thermisches Aufbringen einer oberen Oxidschicht (50) auf der Nitridschicht (48).

7. Verfahren nach Anspruch 6, bei welchem die untere Oxidschicht (46) bei einer Temperatur von 950°C bis 1100°C aufgebracht wird.

8. Feldeffekttransistorstruktur mit schwebendem Gate mit:
einem Halbleitersubstrat (30), welches eine Source (14) und einen von dieser durch einen Kanal getrennten Drain (16) aufweist, um eine Richtung in Kanallänge und eine Richtung in Kanalbreite zu definieren;
einer auf dem Substrat über dem Kanal vorgesehenen, dielektrischen Gateschicht (34);
einem über der dielektrischen Gateschicht angeordneten, schwebenden Gate (18), wobei das schwebende Gate eine Oberseite und ein Paar erste Seitenwände (35) aufweist, welche sich in Richtung der Kanallänge erstrecken und ein Paar zweite Seitenwände (35) vorsieht, welche in Richtung der Kanalbreite verlaufen;
Seitenwandoxidschichten (42) auf den ersten und zweiten Seitenwänden des schwebenden Gates;
einer kombinierten Oxid-Nitrid-Oxid-(ONO) Schicht (44), welche auf der Oberseite des schwebenden Gates vorgesehen ist, wobei die Seitenwandoxidschichten (42) auf den ersten und zweiten Seitenwänden des schwebenden Gates mit einer kombinierten Nitrid-Oxid-Schicht (48,50) versehen sind;
einem über der ONO-Schicht angeordneten Steuergate (20).

## Revendications

1. Procédé de fabrication d'un transistor à effet de champ à grille flottante, dans lequel un canal sépare une source (14) d'un drain (16) dans un substrat semi-conducteur (30) de façon à établir une direction de longueur du canal et une direction de largeur du canal, le procédé comprenant les étapes consistant à :
former une couche de grille flottante (18) sur une couche diélectrique de grille (34) située le long du substrat, la grille flottante possédant une surface de sommet, une paire de premières parois latérales opposées (35) s'étendant suivant la direction de longueur du canal et une paire de secondes parois latérales (35) opposées s'étendant suivant la direction de largeur du canal;
former des couches d'oxyde de paroi latérale (42) sur les premières et secondes parois latérales de la grille flottante;
former ensuite une couche (44) oxyde-nitrure-oxyde composite (ONO) sur la surface de sommet de la couche de grille flottante et sur lesdites couches d'oxyde de paroi latérale;
former une grille de commande (20) sur la couche d'ONO;
former la source (14) et le drain (16) dans le substrat semi-conducteur.

2. Procédé suivant la revendication 1, caractérisé en ce que l'étape de formation des couches d'oxyde de paroi latérale (42) comprend la croissance thermique d'oxyde sur les premières et secondes parois latérales de la couche de grille flottante.

3. Procédé suivant la revendication 2, caractérisé en ce que l'étape de croissance thermique d'oxyde est effectuée à une température comprise entre 850°C et 950°C.

4. Procédé suivant la revendication 3, caractérisé en ce que les couches d'oxyde (42) de paroi latérale sont amenées à croître jusqu'à une épaisseur comprise entre approximativement 40 nm et 80 nm sur les premières et secondes parois latérales de la couche de grille flottante.

5. Procédé suivant la revendication 2, comprenant, en outre, les étapes consistant à :
prévoir une couche de nitrure (38) sur la surface de sommet de la couche de grille flottante, avant de faire croître thermiquement les couches d'oxyde de paroi latérale (42) sur les parois latérales, ladite couche de nitrure laissant libres les premières et secondes parois latérales (35) de la couche de grille flottante;
enlever la couche de nitrure (38) après l'étape de croissance thermique des couches d'oxyde de paroi latérale (42) sur les parois latérales et avant l'étape de formation de la couche d'ONO (44).

6. Procédé suivant l'une quelconque des revendications précédentes, caractérisé en ce que l'étape de formation de la couche d'ONO comprend les étapes consistant à :
faire croître thermiquement une couche d'oxyde inférieure (46) sur la surface de sommet de la couche de grille flottante;
déposer la couche de nitrure (48) sur la couche d'oxyde inférieure et sur les couches d'oxyde de paroi latérale;
faire croître thermiquement une couche d'oxyde supérieure (50) sur la couche de nitrure (48).

7. Procédé suivant la revendication 6, caractérisé en ce que ladite couche d'oxyde inférieure (46) est amenée à croître à une température comprise entre 950°C et 1100°C.

8. Structure de transistor à effet de champ à grille flottante, comprenant :
un substrat de semi-conducteur (30) qui comprend une source (14) et un drain (16) séparés par un canal de façon à définir une direction de longueur du canal et une direction de largeur du canal;
une couche diélectrique de grille (34) située sur le substrat au-dessus du canal;
une grille flottante (18) située au-dessus de la couche diélectrique de grille, la grille flottante possédant une surface de sommet et une paire de premières parois latérales (35), qui s'étendent suivant la direction de longueur du canal et une paire de secondes parois latérales (35), qui s'étendent suivant la direction de largeur du canal;
des couches d'oxyde de paroi latérale (42) situées sur les premières et secondes parois latérales de la grille flottante;
une couche (44) composite d'oxyde-nitrure-oxyde (ONO) prévue sur la surface de sommet de la grille flottante, les couches d'oxyde de paroi latérale (42) sur les premières et secondes parois latérales de la grille flottante étant recouvertes d'une couche composite de nitrure-oxyde (48, 50);
une grille de commande (20) située au-dessus de la couche d'ONO.
